# EUROPÄISCHE PATENTSCHRIFT

(11) **EP 0 928 500 B1**
(45) Veröffentlichungstag und Bekanntmachung des Hinweises auf die Patenterteilung: **10.12.2003**
(21) Anmeldenummer: 97935454.5
(22) Anmeldetag: 22.07.1997
(51) Int. Cl.: H01L 21/762, H01L 21/74

(54) **VERFAHREN ZUR HERSTELLUNG EINER VERGRABENEN, LATERAL ISOLIERTEN ZONE ERHÖHTER LEITFÄHIGKEIT IN EINEM HALBLEITERSUBSTRAT**
METHOD OF PRODUCING A BURIED, LATERALLY INSULATED ZONE OF VERY HIGH CONDUCTIVITY IN A SEMICONDUCTOR SUBSTRATE
PROCEDE POUR PRODUIRE UNE ZONE ENFOUIE ISOLEE LATERALEMENT, DE TRES HAUTE CONDUCTIVITE DANS UN SUPPORT A SEMI-CONDUCTEUR

(30) Priorität: 23.07.1996 DE 19629766
(43) Veröffentlichungstag der Anmeldung: 14.07.1999
(73) Patentinhaber: Infineon Technologies AG, 81669 München (DE)
(72) Erfinder: ELBEL, Norbert, D-81825 München (DE); GABRIC, Zvonimir, D-85604 Zorneding (DE); NEUREITHER, Bernhard, D-81735 München (DE)
(74) Vertreter: Zimmermann & Partner
(86) Internationale Anmeldenummer: DE9701542
(87) Internationale Veröffentlichungsnummer: WO98003991

(56) Entgegenhaltungen:
- EP-A- 0 582 724
- EP-A- 0 647 968
- DE-A- 4 211 050
- US-A- 4 472 240
- US-A- 5 491 108
- US-A- 5 536 675
- PATENT ABSTRACTS OF JAPAN vol. 017, no. 657 (E-1470), 6.Dezember 1993 & JP 05 218031 A (SHARP CORP), 27.August 1993,

## Beschreibung

Die Erfindung betrifft ein Verfahren zur Herstellung einer vergrabenen, lateral isolierten Zone erhöhter Leitfähigkeit in einem Halbleitersubstrat. Die Erfindung betrifft insbesondere ein Verfahren zur Herstellung einer vergrabenen, lateral isolierten Zone erhöhter Leitfähigkeit in einem Halbleitersubstrat durch eine Deep-Trench-Isolation.

Vergrabene Zonen erhöhter Leitfähigkeit, sogenannte "Buried Layers", werden bei einer Vielzahl von Bauelementen der Halbleitertechnik verwendet, um eine laterale Kontaktierung der Bauelemente zu ermöglichen. So ist beispielsweise in der Hochfrequenztechnologie der "buried Layer" bei vertikalen Bipolartransistoren ein Teil des Kollektors.

Damit sich auf einem Chip benachbarte Bauelemente nicht gegenseitig in ihrer Funktion stören, ist es notwendig, daß die Bauelemente durch Isolationsstrukturen voneinander isoliert sind. Besitzen zwei benachbarte Bauelemente jeweils einen "buried Layer", so müssen auch diese "buried layers" voneinander isoliert werden.

Die einfachste Möglichkeit für eine derartige Isolation besteht darin, zwischen den einzelnen Zonen erhöhter Leitfähgkeit ausreichend Platz zu lassen, so daß die einzelnen Zonen durch das Substrat voneinander isoliert sind. Zusätzlich wird zwischen den einzelnen Zonen erhöhter Leitfähigkeit eine weitere Implantation ("channel stopper") eingefügt, die einen sperrenden PN-Übergang erzeugt.

Diese Möglichkeit besitzt jedoch den Nachteil, daß damit die Packungsdichte der Bauelement stark begrenzt ist. Weiterhin hat sich herausgestellt, daß bei Anwendungen in der Hochfrequenztechnologie die erreichbare Grenzfrequenz der Bipolar-Transistoren durch die Kapazität begrenzt ist, die sich zwischen der Zone erhöhter Leitfähigkeit und dem Substrat ausbildet. Um Grenzfrequenzen von größer 50 GHz erreichen zu können, muß diese Zonen-Substrat-Kapazität deutlich verringert werden.

Zur Lösung dieses Problems wurden tiefe, mit Oxid gefullte Gräben ("Deep Trench") vorgeschlagen, die jede Zone erhöhter Leitfähikeit in Form eines geschlossenen Rings vollständig umgeben. Jedoch ergeben sich insbesondere beim Planarisieren der oxidgefüllten Gräben eine Reihe von Schwierigkeiten. Durch das Auffüllen der Gräben werden an der Oberfläche des Halbleiterwafers große Topologieunterschiede erzeugt, die sich störend auf nachfolgende Prozeßschritte auswirken können. Dies hat zur Folge, daß diese Topologieunterschiede durch eine Planarisierung, z.B. eine Rückätzung, wieder entfernt werden müssen. Insbesondere wenn gleichzeitig an der Substratoberfläche eine LOCOS-Isolierung verwendet wird, erfordert eine Planarisierung durch Rückätzen jedoch eine komplexe und teure Prozeßführung.

In dem Dokument EP-A-0 582 724 ist ein Verfahren beschrieben, bei dem die Oberflächen eines strukturierten Siliziumsubstrats so beschaffen sind , daß die SiO₂-Isolationsschicht auf den höher liegenden Oberflächen langsamer wächst als auf den tiefer liegenden.

Aufgabe der vorliegenden Erfindung ist es daher, ein neues Verfahren zur Herstellung einer vergrabenen, lateral isolierten Zone erhöhter Leitfähigkeit in einem Halbleitersubstrat bereitzustellen, das mit geringem Zeit- und Kostenaufwand wirtschaftlich arbeitet und das ein strukturiertes Substrat ermöglicht, das eine optimale Planarität besitzt.

Diese Aufgabe wird von dem Verfahren gemäß Patentanspruch 1 gelöst. Weitere vorteilhafte Ausführungsformen, Ausgestaltungen und Aspekte der vorliegenden Erfindung ergeben sich aus den Unteransprüchen, der Beschreibung und den beiliegenden Zeichnungen.

Erfindungsgemäß wird ein Verfahren zur Herstellung einer vergrabenen, lateral isolierten Zone erhöhter Leitfähigkeit in einem Halbleitersubstrat bereitgestellt, das die folgenden Schritte umfaßt:
a) ein Siliziumsubstrat mit einer vergrabenen Zone, erhöhter Leitfähigkeit wird bereitgestellt;
b) auf das Siliziumsubstrat wird eine Referenzschicht aufgebracht;
c) die Referenzschicht wird strukturiert;
d) in dem Siliziumsubstrat wird ein Graben erzeugt; und
e) auf die so erzeugte Struktur wird das zum Auffüllen des Grabens verwendete Isolationsmaterial aus Siliziumoxid aufgebracht,
wobei die Referenzschicht und das Abscheideverfahren für das Isolationsmaterial so gewählt sind, daß die Wachstumrate des zum Auffüllen des Grabens verwendeten Isolationsmaterials auf der Referenzschicht mindestens um den Faktor 2 kleiner ist als die Wachstumrate des zum Auffüllen des Grabens verwendeten Isolationsmaterials auf der zu bedeckenden Oberfläche des Grabens, wobei als Referenzschicht eine Siliziumnitridschicht , eine Titannitridschicht oder eine Polysiliziumschicht vorgesehen ist. Diese zu bedeckende Oberfläche des Grabens wird üblicherweise aus Substratmaterial bestehen. Es können aber auch Zwischenschichten vorgesehen sein.

Die durch das erfindungsgemäße Verfahren erzeugten, vergrabenen, lateral isolierten Zonen erhöhter Leitfähigkeit lassen dichter packen, wodurch eine höhere Integrationsdichte auf den Halbleiterwafern erzeugt werden kann. Darüber hinaus wird die Kapazität, die zwischen den Zonen erhöhter Leitfähigkeit und dem Substrat gebildet wird, deutlich verringert, wodurch höhere Grenzfrequenzen in der Hochfrequenztechnologie erzielbar sind. Das erfindungsgemäße Verfahren ermöglicht es, die Zonen erhöhter Leitfähigkeit zu isolieren, ohne daß große Topologieunterschiede auf der Oberfläche des Substrats aufgebaut werden.

Bevorzugt ist als Substrat ein Siliziumsubstrat vorgesehen und bevorzugt wird zum Auffüllen des Grabens ein Siliziumoxid verwendet.

Weiterhin ist es bevorzugt, wenn als Referenzschicht eine Siliziumnitridschicht, eine Titannitridschicht oder eine Polysiliziumschicht, insbesondere eine dotierte Polysiliziumschicht, vorgesehen ist. Dabei wird das Siliziumoxid vorteilhafterweise in einem ozonaktivierten CVD-Verfahren, inbesondere SACVD-Verfahren, abgeschieden. Derartige ozonaktivierten CVD-Verfahren sind beispielsweise in der EP 0 582 724 A1 und in der EP 0 537 001 A1 eingehend beschrieben. Insbesondere ein SACVD-Abscheideprozeß zeichnet sich durch sehr gute Fülleigenschaften aus, was dazu führt, daß selbst Gräben mit einem großem Aspektverhältnis von größer als 2:1 lunkerfrei gefüllt werden können.

Bevorzugt wird das zum Auffüllen des Grabens verwendete Material solange aufgebracht, daß sich in der lokalen Umgebung des Grabens eine im wesentlichen planare Oberfläche bildet.

Die Referenzschicht kann direkt auf die Substratoberfläche aufgebracht werden. Alternativ kann jedoch auch zwischen dem Substrat und der Referenzschicht zumindest eine Zwischenschicht, insbesondere eine Oxidschicht (LOCOS-Oxid, Padoxid), vorgesehen sein.

Bevorzugt wird nach dem Aufbringen des zum Auffüllen des Grabens verwendeten Materials eine thermische Oxidation (z. B. 900 - 1000°C für 10 - 30 min) durchgeführt. Diese Oxidation wirkt durch das bereits abschiedene Material, insbesondere durch das bereits abgeschiedene Siliziumoxid, und verringert im Substrat verbliebene Schäden, die während der Erzeugung des Graben auftreten können.

Schäden im Substrat können auch durch eine Lineroxidation nach der Erzeugung des Grabens verringert werden. Allerdings muß das aufgewachsene Oxid anschließend naßchemisch wieder entfernt werden, da sonst die Selektivität des nachfolgenden Abscheideprozesses nicht gegeben ist. Dieses "Opferoxid" entfernt beispielsweise Ätzschäden und stationäre Ladungen an der Grabenkante, die die Isolationseigenschaften des Grabens beeinträchtigen würden.

Bevorzugt wird nach dem Aufbringen des zum Auffüllen des Grabens verwendeten Isolationsmaterials, der Teil des Isolationsmaterials, der über der Höhe der Referenzschicht angeordnet ist, wieder entfernt. Dazu wird vorteilhafterweise ein naßchemisches oder plasmachemisches Verfahren verwendet.

Gemäß einer weiteren bevorzugten Ausführungsform der vorliegenden Erfindung reicht der Graben bis unter die Zone erhöhter Leitfähigkeit.

Weiterhin ist es bevorzugt, wenn der Graben ringförmig ausgebildet ist und die Zone erhöhter Leitfähigkeit lateral vollständig umschließt.

Üblicherweise sind die einzelnen Bauelemente zusätzlich an der Substratoberfläche durch ein Feldoxid, insbesondere ein LOCOS-Oxid, voneinander isoliert. Daher ist es besonders bevorzugt, wenn der Graben zumindest einen flachen Breich und zumindest einen tiefen Bereich aufweist. Auf diese Weise kann der flache Bereich des Grabens das Feldoxid an der Substratoberfläche ersetzt werden und man erhält eine gut planarisierte Substratoberfläche.

Nun kann der Teil des Isolationsmaterials, der über der Höhe der Referenzschicht angeordnet ist, auch durch ein CMP-Verfahren entfernt werden. Da bei der Verwendung der flachen Gräben die Waferoberfläche bereits vor einem anschließenden CMP-Schritt im wesentlichen planar ist, tritt auch bei großen Grabengebieten während eines CMP-Schritts kein nennenswertes "Dishing" auf .

Bevorzugt ist dabei das Verhältnis der Breite des tiefen Bereichs zur Tiefe des flachen Bereichs etwa gleich 2*α /(α - 1), wobei α dem Verhältnis der Wachstumsrate des zum Auffüllen des Grabens verwendeten Materials auf dem Substrat (2) zu der Wachstumsrate des zum Auffüllen des Grabens verwendeten Materials auf der Referenzschicht (5) entspricht. Die beiden Bereiche des Graben lassen sich dadurch auf einfache Weise so auffüllen, daß eine planare Oberfläche des abgeschiedenen Isolationsmaterials entsteht.

Die Erfindung wird nun anhand der Figuren näher erläutert. Gleiche Teile sind in den Figuren mit gleichen Bezugszeichen versehen. Es zeigen:
Fig. 1 bis 3 eine schematische Darstelung des erfindungsgemäßen Verfahrens,
Fig. 4 eine durch das erfindungsgemäße Verfahren erzeugte Bauelementstruktur,
Fig. 5 eine Bauelementstruktur nach dem Stand der Technik, und
Fig. 6 eine weitere durch das erfindungsgemäße Verfahren erzeugte Bauelementstruktur.

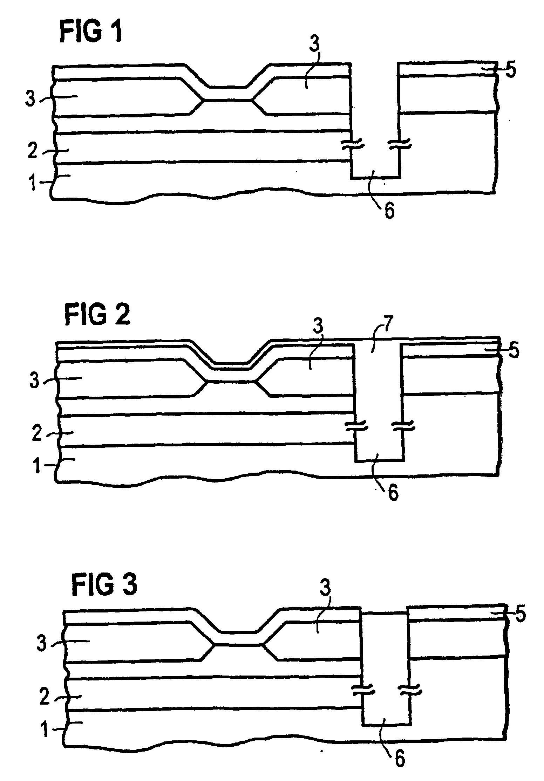

In Figur 1 ist ein Siliziumsubstrat gezeigt und mit 1 bezeichnet. In dem Substrat 1 wurde beispielsweise durch eine Implantation eine Zone 2 erhöhter Leitfähigkeit ("buried layer") erzeugt. Weiterhin befindet sich an der Oberfläche des Substrats 1 eine Feldoxidisolierung 3 (LOCOS-Oxid), die verschiedene Bauelemente und/oder verschiedene Teile eines Bauelements voneinander isoliert.

Auf die Oberfläche des Substrats 1 bzw. des Feldoxids 3 wird eine Siliziumnitridschicht 5 aufgebracht, die als Referenzschicht für die anschließende Grabenfüllung dient. Die Nitridschicht (Si₃N₄) wird mit einem CVD-Verfahren hergestellt.

Anschließend wird die Siliziumnitridschicht mit einer Phototechnik strukturiert und der Graben 6 anisotrop geätzt. Der Graben 6 wird etwa 5 µm tief in das Siliziumsubstrat 1 geätzt und besitzt eine Breite von 1 µm. Die sich daraus ergebende Struktur ist in Fig. 1 gezeigt.

Anschließend wird der Graben 6 mit Siliziumoxid 7 aufgefüllt, welches mit einem ozonaktivierten CVD-Verfahren abgeschieden wird.

Bei der ozonaktivierten Abscheidung von Siliziumoxidschichten können auf unterschiedlich beschaffenen Oberflächen unterschiedliche Aufwachsraten erzielt werden. Im vorliegenden Fall ist die Aufwachsrate von Siliziumoxid auf der Nitridschicht 5 um einen Faktor 5 kleiner als die Aufwachsrate von Siliziumoxid auf dem Silizium bzw. dem Siliziumoxid des Grabens 6. Die Oxidabscheidung wird solange durchgeführt bis sich in der lokalen Umgebung des Grabens 6 eine im wesentlichen planare Oxidoberfläche einstellt.

Als Ausgangssubstanz für die CVD-Abscheidung sind neben TEOS insbesondere OMTC (Octa-Metyl-Zyklo-Tetra-Siloxan) bzw. HMDS (Hexa-Metyl-Disiloxan) geeignet. Die sich daraus ergebende Struktur ist in Fig. 2 gezeigt.

Anschließend wird das über das ozonaktivierte CVD-Verfahren abgeschiedene Siliziumoxid 7 entfernt, welches über der Oberkante der Nitridschicht 5 angeordnet ist. Dies geschieht vorzugsweise durch eine Rückätzung. Die sich daraus ergebende Struktur ist in Fig. 3 gezeigt.

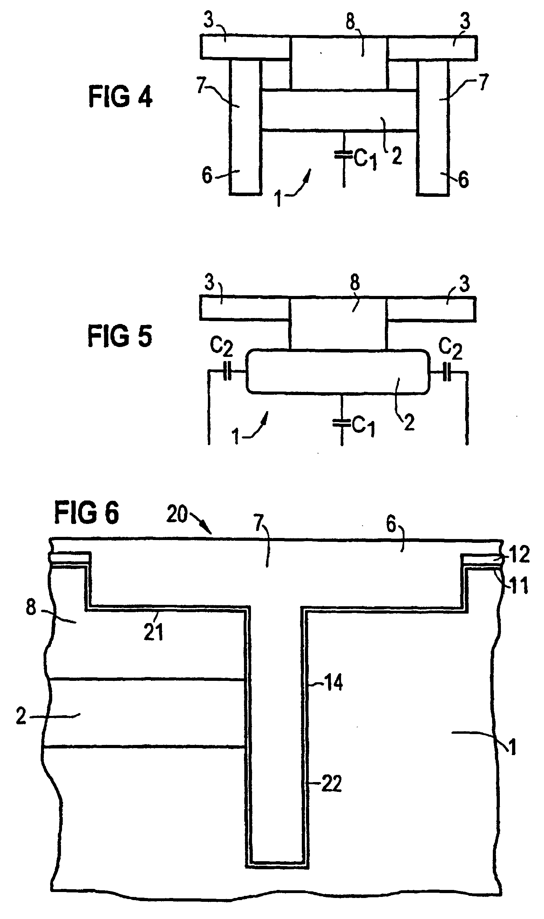

Figur 4 zeigt eine durch das erfindungsgemäße Verfahren erzeugte Bauelementstruktur. Die Bauelementstruktur umfaßt eine Zone 2 erhöhter Leitfähigkeit, die durch einen ringförmig geschlossenen Graben 6 umgeben ist.

Der Graben 6 ist mit Siliziumoxid 7 aufgefüllt und isoliert die Zone 2 erhöhter Leitfähigkeit in lateraler Richtung. Somit bildet sich zwischen der Zone 2 und dem Substrat nur an der Unterseite der Zone 2 eine nennenswerte Kapazität C₁. Über der Zone 2 ist das eigentliche Bauelement 8 angeordnet, das an der Oberfläche des Substrats zusätzlich durch ein Feldoxid 3 isoliert ist.

Im Vergleich dazu zeigt Figur 5 eine Bauelementstruktur nach dem Stand der Technik. Hier ist die Zone 2 nur durch das Substrat 1, gegebenenfalls mit einer zusätzlichen "Channel-Stopper"-Implatation, von anderen Bauelementen (nicht gezeigt) isoliert. Zusätzlich zu der Kapazität C₁ an der Unterseite der Zone 2 bildet sich nun eine weitere Kapazität C₂ an den lateren Seiten der Zone 2. Dies erhöht die Gesamtkapazität zwischen der Zone 2 und dem Substrat 1 und führt bei Anwendungen in der Hochfrequenztechnologie zu einer Limitierung der erreichbaren Grenzfrequenz.

Fig. 6 zeigt eine weitere durch das erfindungsgemäße Verfahren erzeugte Bauelementstruktur. Die Isolationsstruktur 20 umfaßt einen mit Siliziumoxid 7 aufgefüllten Graben 6 in einem Halbleitersubstrat 1. Weiterhin weist die Isolationsstruktur 20 einen flachen Breich 21 auf, der von der Oberfläche einer Siliziumnitridschicht 12 (Referenzschicht) eine Stufenhöhe T besitzt. Darüber hinaus besitzt die Isolationstruktur 20 einen tiefen Bereich 22. Dieser tiefe Bereich 22 isoliert lateral die Zone 2 erhöhter Leitfähigkeit, die in dem Substrat 1 ausgebildet ist. Über der Zone 2 ist wiederum das eigentliche Bauelement 8 angeordnet. Zwischen der Siliziumnitridschicht 12 (Referenzschicht) und dem Substrat ist außerdem ein dünnes Padoxid 11 angeordnet.

Der Bereich 22 der Isolationstruktur 20 besitzt die Breite B. Dabei ist das Verhältnis der Breite B des tiefen Bereichs zur Stufenhöhe T des flachen Bereichs etwa gleich 2*α /(α -1), wobei α dem Verhältnis der Wachstumsrate des zum Auffüllen des Grabens verwendeten Materials auf dem Substrat 1 zu der Wachstumsrate des zum Auffüllen des Grabens verwendeten Materials auf der Nitridschicht 12 entspricht.

Dadurch ist gewährleistet, daß beim Auffüllen der erfindungsgemäßen Isolationsstruktur eine nahezu planare Oberfläche des Siliziumoxids 7 entsteht.

Der flache Bereich 21 des Grabens 6 ersetzt das Feldoxid 3 (siehe Fig. 1 bis 3) an der Substratoberfläche. Im Gegensatz zu einem Feldoxid 3, das durch einen LOCOS-Prozeß erzeugt wurde, besitzt der flache Bereich 21 des Grabens 6 eine gute Planarität. Damit erhält man größere Prozeßfenster z.B. für nachfolgende Lithographieschritte. In diesem Fall kann auch das über die Referenzschicht 12 hinausstehende Siliziumoxid 7 durch einen CMP-Prozeß wieder entfernt werden.

## Patentansprüche

1. Verfahren zur Herstellung einer vergrabenen, lateral isolierten Zone erhöhter Leitfähigkeit in einem Halbleitersubstrat mit den Schritten:
a) ein Siliziumsubstrat (1) mit einer vergrabenen Zone erhöhter Leitfähigkeit wird bereitgestellt;
b) auf das Siliziumsubstrat (1) wird eine Referenzschicht (5; 12) aufgebracht, wobei als Referenzschicht (5; 12) eine Siliziumnitridschicht, eine Titannitridschicht oder eine Polysiliziumschicht vorgesehen ist;
c) die Referenzschicht (5; 12) wird strukturiert;
d) in dem Siliziumsubstrat (1) wird ein Graben (6) erzeugt; und
e) auf die so erzeugte Struktur wird das zum Auffüllen des Grabens verwendete Isolationsmaterial aus Siliziumoxid aufgebracht,
wobei die Referenzschicht (5; 12) und das Abscheideverfahren für das Isolationsmaterial so gewählt sind, daß die Wachstumsrate des zum Auffüllen des Grabens (6) verwendeten Isolationsmaterials auf der Referenzschicht (5; 12) mindestens um den Faktor 2 kleiner ist als die Wachstumsrate des zum Auffüllen des Grabens (6) verwendeten Isolationsmaterials auf der zu bedeckenden Oberfläche des Grabens (6).

2. Verfahren nach Anspruch 1,
**dadurch gekennzeichnet, daß** das Siliziumoxid in einem ozonaktivierten CVD-Verfahren abgeschieden wird.

3. Verfahren nach einem der vorherstehenden Ansprüche,
**dadurch gekennzeichnet, daß** das zum Auffüllen des Grabens (6) verwendete Isolationsmaterial solange aufgebracht wird, daß sich eine in der Umgebung des Grabens 6 im wesentlichen planare Oberfläche bildet.

4. Verfahren nach einem der vorherstehenden Ansprüche,
**dadurch gekennzeichnet, daß** zwischen dem Substrat (1) und der Referenzschicht (5; 12) zumindest eine Zwischenschicht (3, 11), insbesondere eine Oxidschicht vorgesehen ist.

5. Verfahren nach einem der vorherstehenden Ansprüche,
**dadurch gekennzeichnet, daß** nach dem Aufbringen des zum Auffüllen des Grabens (6) verwendeten Isolationsmaterials eine thermische Oxidation durchgeführt wird.

6. Verfahren nach einem der vorherstehenden Ansprüche,
**dadurch gekennzeichnet, daß** nach der Erzeugung des Grabens (6) eine Lineroxidation durchgeführt wird.

7. Verfahren nach einem der vorherstehenden Ansprüche,
**dadurch gekennzeichnet, daß** nach dem Aufbringen des zum Auffüllen des Grabens verwendeten Isolationsmaterials, der Teil des Isolationsmaterials, der über der Höhe der Referenzschicht (5; 12) angeordnet ist, wieder entfernt wird.

8. Verfahren nach einem der vorherstehenden Ansprüche,
**dadurch gekennzeichnet, daß** der Graben (6) bis unter die Zone (2) erhöhter Leitfähigkeit reicht.

9. Verfahren nach einem der vorherstehenden Ansprüche,
**dadurch gekennzeichnet, daß** der Graben (6) ringförmig ausgebildet ist und zumindest ein Teil der Zone (2) erhöhter Leitfähigkeit lateral vollständig umschließt.

10. Verfahren nach einem der vorherstehenden Ansprüche,
**dadurch gekennzeichnet, daß** der Graben zumindest einen flachen Breich (21) und zumindest einen tiefen Bereich (22) aufweist.

11. Verfahren nach Anspruch 10,
**dadurch gekennzeichnet, daß** das Verhältnis der Breite des tiefen Bereichs zur Stufenhöhe des flachen Bereichs etwa gleich 2*α /(α -1) ist, wobei α dem Verhältnis der Wachstumsrate des zum Auffüllen des Grabens verwendeten Isolationsmaterials auf der zu bedeckenden Oberfläche des Grabens (6) zu der Wachstumsrate des zum Auffüllen des Grabens verwendeten Isolationsmaterials auf der Referenzschicht (12) entspricht.

12. Verfahren nach einem der Ansprüche 10 oder 11,
**dadurch gekennzeichnet, daß** der Teil des Isolationsmaterials, der über der Höhe der Referenzschicht (12) angeordnet ist, durch ein CMP-Verfahren wieder entfernt wird.

## Claims

1. Process for fabricating a buried, laterally insulated zone of increased conductivity in a semiconductor substrate, having the following steps:
a) a silicon substrate (1) with a buried zone of increased conductivity is provided;
b) a reference layer (5;12) is applied to the silicon substrate (1), a silicon nitride layer, a titanium nitride layer or a polysilicon layer being provided as the reference layer (5, 12);
c) the reference layer (5;12) is patterned;
d) a trench (6) is produced in the silicon substrate (1); and
e) the insulation material made of silicon oxide and used for filling the trench is applied to the structure thus produced,
in which case the reference layer (5;12) and the deposition process for the insulation material are chosen such that the growth rate of the insulation material used for filling the trench (6) on the reference layer (5;12) is at least a factor of 2 less than the growth rate of the insulation material used for filling the trench (6) on the surface of the trench (6) which is to covered.

2. Process according to Claim 1,
**characterized in that** the silicon oxide is deposited in an ozone-activated CVD process.

3. Process according to one of the preceding claims,
**characterized in that** the insulation material used for filling the trench (6) is applied until a surface which is essentially planar in the surroundings of the trench 6 is formed.

4. Process according to one of the preceding claims,
**characterized in that** at least one intermediate layer (3,11), in particular an oxide layer, is provided between the substrate (1) and the reference layer (5;12).

5. Process according to one of the preceding claims,
**characterized in that** after the application of the insulation material used for filling the trench (6), thermal oxidation is carried out.

6. Process according to one of the preceding claims,
**characterized in that** after the production of the trench (6) liner oxidation is carried out.

7. Process according to one of the preceding claims,
**characterized in that** after the application of the insulation material used for filling the trench, that part of the insulation material which is arranged above the level of the reference layer (5;12) is removed again.

8. Process according to one of the preceding claims,
**characterized in that** the trench (6) reaches down to a point below the zone (2) of increased conductivity.

9. Process according to one of the preceding claims,
**characterized in that** the trench (6) is of annular . design and laterally completely encloses at least part of the zone (2) of increased conductivity.

10. Process according to one of the preceding claims,
**characterized in that** the trench has at least one shallow region (21) and at least one deep region (22) .

11. Process according to Claim 10,
**characterized in that** the ratio of the width of the deep region to the step height of the shallow region is approximately equal to 2*α /(α - 1), where α corresponds to the ratio of the growth rate of the insulation material used for filling the trench on the surface of the trench (6) which is to be covered to the growth rate of the insulation material used for filling the trench on the reference layer (12).

12. Process according to either of Claims 10 and 11,
**characterized in that** that part of the insulation material which is arranged above the level of the reference layer (12) is removed again by a CMP process.

## Revendications

1. Procédé pour produire une zone enfouie, isolée latéralement, de conductivité accrue dans un substrat à semi-conducteur, comportant les étapes :
a) on met à disposition un substrat (1) de silicium ayant une zone enfouie de conductivité accrue ;
b) on dépose sur le substrat (1) en silicium une couche (5 ; 12) de référence, une couche de nitrure de silicium, une couche de nitrure de titane ou une couche de polysilicium étant prévue comme couche (5 ; 12) de référence ;
c) on structure la couche (5 ; 12) de référence ;
d) on produit dans le substrat (1) en silicium un sillon (6) ; et
e) on dépose sur la structure ainsi produite le matériau d'isolation en oxyde de silicium utilisé pour remplir le sillon,
la couche (5 ; 12) de référence et le procédé de dépôt pour le matériau d'isolation étant choisis de manière que la vitesse de croissance sur la couche (5 ; 12) de référence du matériau d'isolation utilisé pour remplir le sillon (6) soit inférieure d'au moins le facteur 2 à la vitesse de croissance, sur la surface du sillon (6) à recouvrir, du matériau d'isolation utilisé pour remplir le sillon (6).

2. Procédé suivant la revendication 1,
**caractérisé en ce que** l'on dépose l'oxyde de silicium dans un procédé CVD activé par l'ozone.

3. Procédé suivant l'une des revendications précédentes,
**caractérisé en ce que** l'on dépose le matériau d'isolation utilisé pour remplir le sillon (6) jusqu'à ce qu'il se forme une surface sensiblement planaire aux alentours du sillon (6).

4. Procédé suivant l'une des revendications précédentes,
**caractérisé en ce qu'**il est prévu entre le substrat (1) et la couche (5 ;12) de référence au moins une couche (3, 1) intermédiaire, notamment une couche d'oxyde.

5. Procédé suivant l'une des revendications précédentes,
**caractérisé en ce que** l'on effectue après le dépôt du matériau d'isolation utilisé pour remplir le sillon (6) une oxydation thermique.

6. Procédé suivant l'une des revendications précédentes,
**caractérisé en ce que** l'on effectue une liner oxydation après la production du sillon (6).

7. Procédé suivant l'une des revendications précédentes,
**caractérisé en ce que** l'on enlève après le dépôt du matériau d'isolation utilisé pour remplir le sillon la partie du matériau d'isolation qui est disposée au-dessus du niveau de la couche (5 ; 12) de référence.

8. Procédé suivant l'une des revendications précédentes,
**caractérisé en ce que** le sillon (6) va jusqu'au-dessous de la zone (2) de conductivité accrue.

9. Procédé suivant l'une des revendications précédentes,
**caractérisé en ce que** le sillon (6) est réalisé en forme d'anneau et entoure totalement latéralement au moins une partie de la zone (2) de conductivité accrue.

10. Procédé suivant l'une des revendications précédentes,
**caractérisé en ce que** le sillon comporte au moins une région (21) plane et une région (2) profonde.

11. Procédé suivant la revendication 10,
**caractérisé en ce que** le rapport de la largeur de la région profonde à la hauteur de palier de la région plane est à peu près égal à 2*α / (α - 1), α correspondant au rapport de la vitesse de croissance, sur la surface du sillon (6) à recouvrir, du matériau d'isolation utilisé pour remplir le sillon à la vitesse de croissance, sur la couche (12) de référence, du matériau d'isolation utilisé pour remplir le sillon.

12. Procédé suivant l'une des revendications 10 ou 11,
**caractérisé en ce que** l'on enlève à nouveau par un procédé CMP la partie du matériau d'isolation qui est située au-dessus du niveau de la couche (12) de référence.
